# EUROPÄISCHE PATENTANMELDUNG

(11) **EP 1 628 400 A1**
(43) Veröffentlichungstag der Anmeldung: **22.02.2006**
(21) Anmeldenummer: 05017924.1
(22) Anmeldetag: 18.08.2005
(51) Int. Cl.: H03M 7/40, H04Q 7/22

(54) **Verfahren zur Komprimierung von kurzen Textdaten**

(30) Priorität: 19.08.2004 DE 102004040200
(71) Anmelder: Schröder, Christian, 33803 Steinhagen (DE); Wessler, Olaf, 86343 Königsbrunn (DE)
(72) Erfinder: Schröder, Christian, 33803 Steinhagen (DE); Wessler, Olaf, 86343 Königsbrunn (DE)

(57) **Zusammenfassung**

Verfahren zur Komprimierung von - vorzugsweise kurzen - Textdaten, insbesondere Kurznachrichten (SMS) durch Codierung von einzelnen Buchstaben, Wörtern, Zeichen und Zeichenketten mit Binärcodes

## Beschreibung

Die vorliegende Erfindung betrifft ein Verfahren zur Komprimierung von kurzen Textdaten, insbesondere Kurznachrichten (SMS) für Mobilgeräte. Kurznachrichten erfreuen sich im Mobilfunkmarkt weiterhin wachsender Beliebtheit, allein in Deutschland wurden im Jahr 2004 mehr als 23 Mrd. SMS verschickt. Mittlerweile wird ein großer Teil des Umsatzes der Telekommunikationsanbieter im Mobilfunksegment mit Kurznachrichten erwirtschaftet. Wesentliche Vorteile der SMS gegenüber anderen mobilen Kommunikationsformen für den Kunden sind der garantierte Zugang der Mitteilung beim Empfänger ohne expliziten Annahmeprozess (Push Funktion) und die im Vergleich zu anderen Diensten geringen Kosten pro Verbindung. Für die Mobilfunkanbieter ist die SMS lukrativ, da die Übertragung auf dem Signalisierungskanal erfolgt und daher keinen Datenverkehr auf den Nutzkanälen verursacht. Die SMS Übertragung kann damit parallel zu anderen Diensten, etwa einem laufenden Telefongespräch erfolgen.

Die wesentliche Einschränkung ist die für eine SMS maximal zur Verfügung stehende Datenmenge von 140 Byte Nutzdaten, entsprechend 160 Zeichen zu je 7 Bit. Zwar besteht die Möglichkeit, mehrere SMS aneinander zu hängen (concatenated SMS / EMS), dabei addieren sich allerdings auch die Kosten zu einer Summe, die in keinem Verhältnis mehr zu der übertragenen Informationsmenge steht. Ähnliche Probleme haben auch andere sehr kurze Texte, wie etwa EMails oder Chat-Texte.

Aus dem PC Umfeld sind verschiedene Kompressionsalgorithmen für Textdaten bekannt. Diese erzeugen eine umso bessere Kompression, je größer die Ausgangsdatei ist, da sie neben den komprimierten Nutzdaten noch einen Header mit Informationen über die Komprimierung beifügen müssen. Angesicht der begrenzten Länge einer SMS versagen diese Algorithmen dort, vielfach erzeugen sie sogar einen längeren Code als der Ausgangstext. Dabei zielen die meisten Kompressionsalgorithmen auf eine Komprimierung beliebiger Daten ab, was im Falle von Kurznachrichten demnach weder notwendig noch sinnvoll ist.

Bekannt ist ein Komprimierungsverfahren für Kurznachrichten, bei dem häufig vorkommende Zeichenketten durch ein Sonderzeichen ersetzt werden. Dabei wird sich zu nutze gemacht, dass aus dem SMS Zeichensatz von 128 Zeichen (7 Bit) nur einige Zeichen, wie z.B. das Alphabet und die Ziffern, häufig verwendet werden, Sonderzeichen, wie z.B. §, &, # dagegen sehr selten. Dabei ergibt sich das Problem, dass es sehr viele verschiedene Zeichenketten gibt, allein bei 2 Buchstaben ergeben sich 676 Kombinationsmöglichkeiten (ohne Umlaute). Um diese zu codieren, benötigt man schon 10 Bit, bei 3 Buchstaben sogar 15 Bit. Vergleicht man diese mit den ursprünglich für die Zeichenkette benötigten 14 (2*7) bzw. 21 (3*7) Bit, so ergibt sich nur eine magere Kompressionsrate von ca. 30%. Auch bei längeren Zeichenketten ist die Kompressionsrate im Grenzfall auf 50 % beschränkt, wobei Ziffern, Satzzeichen etc noch gar nicht berücksichtigt wurden.
Wortweise Komprimierungsverfahren aus einem Wortschatz scheitern ebenfalls an der großen Menge verwendeter Wörter und der damit verbundenen langen Codes, die bei den häufig vorkommenden kurzen Wörtern oft deren eigene Länge selbst übersteigen.

Aufgabe der vorliegenden Erfindung ist es, ein Verfahren vorzuschlagen, mit dem es möglich wird, sehr kurze Texte, wie z.B. Kurznachrichten um einen hohen Faktor von typischerweise 3:1 bzw. 66% verlustfrei zu komprimieren.
Dadurch können mit einer SMS beispielsweise ca. 480 Zeichenversendet werden, womit sich neue Anwendungsgebiete eröffnen, die bisher deutlich teureren Diensten wie z. B. der MMS oder der Datenübertragung per GPRS (E-Mail) vorbehalten waren. Insbesondere Abo-Informationsdienste wie Wettervorhersage, Börsenkurse oder Nachrichten lassen sich auf diese Weise sehr kostengünstig zum Kunden übertragen.

Ein solches Verfahren lässt sich einfach auf einem Mobiltelefon installieren, z.B. in Form eines Java-Programmes. Zum Versenden und Empfangen der komprimierten Kurznachricht ist es notwendig, dass beide Parteien das Programm selbst oder der Empfänger eine Reader-Variante auf dem Gerät installiert haben. Auch für die Kommunikation zwischen Mobilgerät und dem Festnetz bzw. Internet lässt sich das Verfahren verwenden, sofern die jeweilige Endstelle oder ein zwischengeschalteter Gateway das Komprimierungsverfahren beherrscht.

Grundlage der vorliegenden Erfindung ist eine wort- und zeichenweise Codierung des Ausgangstextes in vorgegebene Binärcodes. Im Gegensatz zu anderen Kompressionsverfahren setzt sich der Code zusammen aus einem Basiscode mit fester Länge und einem in Abhängigkeit des Basiscodes festgelegten Codezusatz mit variabler Länge. Diese wiederum ist abhängig von der Länge und absoluten Häufigkeit des entsprechenden Wortes bzw. Zeichens. Es ergeben sich Codes mit verschiedenen Längenstufen, aber einer konstanten Basis. Dem liegt zugrunde, dass die im Alltag verwendete Sprache einen speziellen Wortschatz umfasst, bei dem bestimmte Wörter oder Klassen von Wörtern überproportional häufig vorkommen, andere entsprechend selten.
Die Bitstufen des Kompressionsverfahrens können nun so gestaltet werden, dass alle gebräuchlichen Wörter einer Längenklasse und / oder Häufigkeitsklasse auch in eine entsprechende Bitstufe passen und somit eine annähernd konstant hohe Kompressionsrate für alle Wörter unabhängig von deren Länge erreicht wird.
Da auf Mobiltelefonen nur ein begrenzter Speicherplatz zur Verfügung steht, lässt sich ein alles umfassender Wortschatz dort nicht ablegen; eine Vorselektion der Wörter in Abhängigkeit der Verwendungshäufigkeit ist notwendig.

Der Basiscode, der beispielsweise 6 Bit lang ist (also 2⁶=64 verschiedene Wörter bzw. Zeichen codieren kann), ist unterteilt in verschiedene Zahlenbereiche. Die Unterteilung erfolgt dabei nicht Bitweise (vertikal), sondern anhand der entsprechenden Binärzahlenwerte, also "horizontal". Jeder Code eines Zahlenbereiches repräsentiert dabei entweder direkt ein Zeichen oder gibt in Abhängigkeit des Zahlenbereiches, in dem er sich befindet, an, wie viele weiter folgende Bits zusammen mit dem Basiscode den Code für ein Zeichen oder Wort darstellen. Auf diese Weise kann jedem Wort ein Code zugeteilt werden, der etwa ein drittel oder weniger der Länge des Wortes ausmacht. Gleichzeitig lässt sich eine genügend große Zahl an Wörtern codieren. Durch die konstante Länge des Basiscodes wird eine schnelle und einfache Decodierung möglich.

Neben Wörtern lassen sich auf diese Weise auch Zeichenketten, wie z.B. Smileys oder mehrfache Ausrufungs- bzw. Fragezeichen durch einen Code ersetzen, ebenso häufige Wortgruppen bzw. Satzphrasen. Sogar unbekannte Wörter werden immer noch leicht komprimiert, da anstelle der üblichen 7 Bit jeder Buchstabe nur mit den 6 Bit des Basiscodes codiert wird.
Seltene Sonderzeichen werden ebenfalls durch einen Code ersetzt, wodurch sie zwar etwas länger werden, dies spielt aber angesichts der Seltenheit solcher Zeichen praktisch keine Rolle.
Als Unterscheidungskriterium zwischen zwei Wörtern oder Zeichenketten bietet sich das Leerzeichen an. Auch Satzzeichen können zur Unterscheidung herangezogen werden.

Eine weitere vorteilhafte Ausgestaltungsform sieht vor, dass zwischen den Codes in der komprimierten SMS keine Leerzeichen eingefügt werden, da diese redundant sind und sich beim Decodieren wieder einfügen lassen.

Eine weitere vorteilhafte Ausgestaltungsvariante sieht vor, dass Großbuchstaben bzw. groß geschriebene codierte Wörter durch ein vor das Wort bzw. den Code eingefügtes Shift-Zeichen gekennzeichnet werden. Somit werden sämtliche Großbuchstaben des Zeichensatzes eingespart. Neben dem Shift-Zeichen kann auch das Shift-Lock Zeichen für komplett groß geschriebene Texte oder Textbereiche verwendet werden.

Eine weitere Vorteilhafte Ausgestaltungsvariante sieht vor, unbekannte Wörter zu zerlegen in einen bereits bekannten Wortstamm, der codiert werden kann, und eine Wortendung und / oder einen Wortanfang, die zeichenweise codiert angefügt werden. Auf diese Weise kann man die in der deutschen Sprache vorkommenden zusammengesetzten Wörter, grammatikalischen Fälle und weitere Abwandlungen abdecken. Beispiel: 'München' hat den Code #1, 'Münchens' ergibt: #1s und 'Münchener': #1er usw.

Eine weitere vorteilhafte Ausgestaltungsform sieht vor, dass jeder variable Codezusatz jeweils in bestimmten Längenkategorien auftritt und alle zu codierenden Wörter des Wortschatzes in Abhängigkeit von ihrer Länge und der absoluten Häufigkeit im Sprachgebrauch in eine Kategorie einsortiert werden.

Eine weitere vorteilhafte Ausgestaltungsvariante sieht vor, dass die Wörter des Wortschatzes derart in Tabellen abgelegt werden, das eine Tabelle genau einer Häufigkeitsklasse zugeordnet ist und der Code eines Wortes sich aus dessen Position innerhalb der Tabelle und einem Offset für die Tabelle errechnet. Dadurch lässt sich der Speicherplatz für den Code einsparen. Vorteilhafterweise sind die Wörter in der Tabelle alphabetisch sortiert.

Eine weitere vorteilhafte Ausgestaltungvariante sieht vor, dass neben Zeichen, Zeichenketten, Wörtern und Wortketten auch Non-Text Content wie zB.: Steuerzeichen oder Meta-Text codiert werden kann.

Eine weitere vorteilhafte Ausgestaltungsvariante sieht vor, dass Wörter, die beim Codieren nicht gefunden werden können, nach einem Verfahren zur Suche mehrfach vorhandener Wortstämme innerhalb eines Wortes untersucht werden; dazwischen enthaltene Zeichen, die vor, nach und zwischen den Stämmen liegen, werden dann zeichenweise codiert. Beispiel: Das beispielsweise unbekannte Wort: "Wirtschaftsprüfer" wird zerlegt in die bekannten Wörter "Wirtschaft" und "Prüfer" und entsprechend hoch codiert, das Bindungs-,s' wird einzeln codiert (zB. mit 6 Bit).
Um sicherzustellen, dass beim Decodieren zwischen den Stämmen kein Leerzeichen eingefügt wird, kann im Code ein Steuerzeichen (NoSpace-Zeichen) eingefügt werden.

Die weitere Beschreibung der Erfindung erfolgt anhand einer konkreten Ausgestaltungsform für den Algorithmus:
Der Basiscode hat 6 Bit, somit lassen sich 2⁶ = 64 Zeichen codieren. Diese 64 möglichen Zeichen werden unterteilt in 6 Bereiche:
1. Die Zeichen 0 - 28 stellen direkt die Buchstaben des Alphabets und die häufigsten Satzzeichen, wie Punkt und Komma dar.
2. Die Zeichen 29 - 31 ergeben zusammen mit den folgenden 3 Bit einen Coderaum für 3 * 2³ = 24 Zeichen. Hiermit werden seltenere Satzzeichen, sowie Ziffern und Umlaute codiert.
3. Die Zeichen 33 - 40 ergeben zusammen mit den folgenden 3 Bit einen Coderaum von 8 * 2³ = 64 sehr kurzen Wörtern, die eine Codelänge von 6 + 3 = 09 Bit haben. Häufige Wörter mit 2 oder 3 Buchstaben werden hier abgelegt.
4. Die Zeichen von 41 - 48 ergeben zusammen mit den folgenden 6 Bit einen Coderaum von 8 * 2⁶ = 512 kurzen Wörtern, die eine Codelänge von 6 + 6 = 12 Bit haben. Wörter mit 3, 4 oder 5 Buchstaben können mit diesen Codes effektiv codiert werden.
5. Die Zeichen von 49 - 56 ergeben zusammen mit den folgenden 8 Bit einen Coderaum von 8 * 2⁸ = 2048 mittellange Wörter mit einer Codelänge von 14 Bit.
6. Die Zeichen 59 - 62 ergeben zusammen mit den folgenden 12 Bit einen Coderaum von 4 * 2¹² = 16384 lange Wörter mit einer Codelänge von 6 + 12 = 18 Bit.

Oben nicht genannte Zeichen sind für zukünftige Verwendung freigehalten.
Insgesamt lassen sich so neben den 52 Buchstaben und Satzzeichen weitere 19008 Wörter speichern, wobei einige Wörter auch Zeichenketten oder seltene Sonderzeichen sind.

Der Ausgangstext wird nun in die entsprechenden Elemente wie Wörter, Wortstämme, einzelne Buchstaben oder Zeichen und Zeichenketten zerlegt (nachfolgend auch für alles Wörter). Die Trennung erfolgt anhand des Leerzeichens oder anhand von Satzzeichen. Die zerlegten Wörter werden nun mit den Wörtern des Wortschatzes verglichen und bei Übereinstimmung wird der zugehörige Code in die zu versendende Datei geschrieben. Wird keine Übereinstimmung gefunden, so wird das Wort zeichenweise codiert. Die Wörter des Wortschatzes sind mit den zugehörigen Codes in einer Tabelle oder Datenbank derart abgelegt, sodass sie sich mit bekannten Suchverfahren schnell finden lassen.

Ein kurzes und häufiges Wort wie z. B. "das" hat normalerweise 4 * 7 = 28 Bit Speicherbedarf (3 Buchstaben plus ein nachfolgendes Leerzeichen), mit 9 Bit codiert ergibt sich eine Komprimierungsrate von besser als 3:1. Ein längeres Wort wie z. B. "gemacht" hat mit dem nachfolgenden Leerzeichen 8 * 7 = 56 Bit, codiert mit 14 Bit ergibt sich eine Rate von 4:1.

Beim Decodieren der Kurznachricht brauchen nur die jeweils nächsten 6 Bit der eingehenden Datei ausgelesen zu werden, anhand des darin codierten Zeichens lässt sich erkennen, zu welchem Bereich das Zeichen gehört und ob hier direkt ein Buchstabe vorliegt, oder ein Wort, zu dessen Decodierung gegebenenfalls noch folgende Bits eingelesen und zusammen mit den ersten 6 Bit entschlüsselt werden müssen.

## Patentansprüche

1. Verfahren zur verlustfreien Komprimierung von - vorzugsweise kurzen - Textdaten, insbesondere Kurznachrichten (SMS) durch Codierung von einzelnen Buchstaben, Wörtern, Zeichen und Zeichenketten mit Binärcodes, **gekennzeichnet durch**:
- Alle Codes bestehen aus einem Basiscode mit fester Länge und abhängig davon einem Codezusatz mit variabler Länge.
- Der Basiscode ist aufgeteilt in verschiedene Zahlenbereiche, aus denen sich die Länge des Codezusatzes ergibt.
- Die Länge des Codezusatzes erfolgt in Abhängigkeit von der Länge und Häufigkeit im Sprachgebrauch des zu codierenden Wortes, Zeichens oder Zeichenkette.
- Die Aufteilung des Basiscodes in Bereiche erfolgt nicht Bitweise, sondern anhand der dem Binärcode entsprechenden Binärzahl.
- Ausgesuchte Zeichen werden ohne Codezusatz nur mit einem Basiscode codiert.
- Die einzelnen Codes werden zu einer Datei aneinandergehängt, die den komprimierten Ausgangstext enthält.
- Wörter, Buchstaben, Zeichen oder Zeichenketten, denen kein Code zugeordnet werden kann, werden zeichenweise codiert.

2. Verfahren nach Anspruch 1, **dadurch gekennzeichnet, dass** von dem Wort, dem kein Code zugeordnet werden kann, solange der jeweils erste oder letzte Buchstabe abgetrennt wird, bis das verbleibende Wort als sogenannter Wortstamm einem Code entspricht und die abgetrennten Buchstaben dem Code als zeichenweise beigefügt werden.

3. Verfahren nach einem der vorhergehenden Ansprüche, **dadurch gekennzeichnet, dass** die Wörter des Zeichensatzes in Tabellen angeordnet sind und sich der zugehörige Code eines Wortes aus der Position des Wortes in der Tabelle und einem Offset für die Tabelle errechnet.

4. Verfahren nach einem der vorhergehenden Ansprüche, **dadurch gekennzeichnet, dass** zur Kennzeichnung von Großbuchstaben ein Shift-Zeichen als Code eingefügt wird. Ebenso kennzeichnet ein Shift-Lock Code längere Passagen aus Großbuchstaben.

5. Verfahren nach einem der vorhergehenden Ansprüche, **dadurch gekennzeichnet, dass** zwischen zwei Codes in der komprimierten Datei keine Leerzeichen eingefügt werden und diese beim Dekomprimieren zwischen den ausgeschriebenen Wörtern oder Zeichenketten wieder eingefügt werden.

6. Verfahren nach einem der vorhergehenden Ansprüche, **dadurch gekennzeichnet, dass** der Basiscode 6 Bit lang ist und aufgeteilt ist in sechs Bereiche, denen jeweils 0, 3, 6, 8 und 12 Bit Codezusatz angehängt werden. Der 3 Bit Zusatz unterteilt sich nochmals in zwei Bereiche für Zeichen und Wörter.

7. Verfahren nach einem der vorhergehenden Ansprüche, **dadurch gekennzeichnet, dass** neben Zeichen und Wörtern auch Non-Text wie zB.: Steuerzeichen und Meta-Text codiert werden können.

8. Verfahren nach einem der vorhergehenden Ansprüche, **dadurch gekennzeichnet, dass** nicht bekannte Wörter nicht nur in einen bekannten Wortstamm und die zeichenweise codierte Endung aufgeteilt werden, sondern das Wort auch in mehrere Stämme und gegebenenfalls einzeln codierte Zeichen zwischen den Stämmen aufgeteilt wird.

9. Verfahren nach Anspruch 8, **dadurch gekennzeichnet, dass** zwischen den Codes der einzelnen codierten Stämmen ein Steuerzeichen eingefügt wird, welches signalisiert, dass diese Stämme beim decodieren direkt aneinander gefügt werden müssen, ohne wie sonst üblich ein Leerzeichen dazwischen einzufügen.
